# EUROPÄISCHE PATENTANMELDUNG

(11) **EP 2 833 248 A1**
(43) Veröffentlichungstag der Anmeldung: **04.02.2015**
(21) Anmeldenummer: 14179218.4
(22) Anmeldetag: 31.07.2014
(51) Int. Cl.: G06F 3/044

(54) **Kapazitive Sensorvorrichtung mit elektrisch leitfähig beschichteter Sensorplatte aus Glas**

(30) Priorität: 31.07.2013 DE 102013215060
(71) Anmelder: Irlbacher Blickpunkt Glas GmbH, 92539 Schönsee (DE)
(72) Erfinder: Irlbacher, Günther, 92539 Schönsee (DE); Stoppa, Alexander, 92539 Schönsee (DE); Winter, Peter, 92559 Winklarn (DE)
(74) Vertreter: Hinkelmann, Klaus

(57) **Zusammenfassung**

Die Erfindung betrifft eine kapazitive Sensorvorrichtung 1 mit einer Frontplatte 2 aus Glas und einer elektrisch leitfähig beschichteten Sensorplatte 7 aus Dünnglas (Dicke im Bereich von 0,2 bis 2 mm), wobei auf der Sensorplatte 7 eine keramische Leitstruktur 10,11 aus einer eingebrannten keramischen Leitpaste angeordnet ist. Die Erfindung betrifft außerdem ein Verfahren zur Herstellung der kapazitiven Sensorvorrichtung 1.

## Beschreibung

Die Erfindung betrifft eine kapazitive Sensorvorrichtung mit einer Frontplatte aus Glas und einer elektrisch leitfähig beschichteten Sensorplatte aus Dünnglas sowie ein bevorzugtes Verfahren zu deren Herstellung.

Berührungsempfindliche Sensorvorrichtungen, auch Touchscreens genannt, werden immer häufiger in vielfältigen Bereichen eingesetzt, wie zum Beispiel als Bedienpanel zur Steuerung von Haushaltsgeräten, Maschinen und Anlagen, bei Elektrokleingeräten wie Computern, Telefonen und ähnlichem. Im Gegensatz zu mechanischen Druckschaltern sind berührungsempfindliche Sensorvorrichtungen weniger abnutzungsanfällig, leicht zu reinigen und werden von Benutzern als ästhetisch ansprechend empfunden. Insbesondere wurden in den letzten Jahren zunehmend Sensorvorrichtungen der so genannten "Projected Capacitive Touch" (PCT)-Technologie eingesetzt, bei der die Touch-Erkennung durch eine Schutzscheibe vor einem Display ermöglicht wird. Solche PCT-Touchscreens können wetterbeständig ausgebildet sein, wodurch sie insbesondere auch im Außenbereich eingesetzt werden können.

Bei Sensorvorrichtungen befinden sich üblicherweise die Sensorelektroden auf einem Sensorsubstrat, beispielsweise aus Glas oder Kunststoff. Dabei ermöglicht ein Glassubstrat durch seine Transparenz nicht nur die Anordnung vor einem Display, sondern erfüllt auch durch seine dielektrischen Eigenschaften alle Anforderungen, die an Leiterplatten für elektronische Schaltungen mit hoher Integrationsdichte und Höchstfrequenzen gestellt werden. Insbesondere wird zunehmend Dünnglas als Sensorsubstrat eingesetzt, um möglichst dünne Sensorvorrichtungen zu erhalten, die ein geringes Gesamtgewicht sowie eine geringe Gesamtdicke aufweisen.

Außerdem beinhalten insbesondere PCT-Sensorvorrichtungen häufig voneinander getrennte Sensorschichten für die Detektion einerseits in Richtung einer X-Achse und für die Detektion andererseits in Richtung einer Y-Achse, wodurch die Berührungsposition nicht nur auf kleinen vordefinierten Sensorfeldern sondern über den gesamten Bereich bestimmbar ist. Diese Sensorschicht ist zumeist durch eine Indium-Zinn-Oxid (ITO)-Beschichtung gebildet, die entsprechend in X- oder Y-Richtung strukturiert wird. Zusätzlich werden dann je nach Layout weitere metallische Leitstrukturen wie z.B. Leiterbahnen und Widerstände angeordnet.

So offenbart die EP 2 439 622 A1 ein Bedien- und Beobachtungsgerät mit zwei berührungssensitiven Sensoren, das derart ausgebildet sein kann, dass zwei Glasscheiben miteinander über Abstandshalter verbunden sind und an den einander zugewandten Oberflächen mit ITO beschichtet sind. Die mit ihrer nicht mit ITO beschichteten Seite dem Benutzer zugewandte Glasscheibe kann beispielsweise als Dünnglasscheibe ausgestaltet sein, wobei die auf der Dünnglasscheibe angebrachte ITO-Schicht sowohl als Sensor für den kapazitiven Touch-Sensor als auch als eine Schicht des resistiven Touch-Sensors dient.

Die US 2011/0030209 A1 beschreibt ein Verfahren zur Herstellung von dünnen Touch-Sensor-Panelen, bei denen auf einer oder beiden Seiten des dünnen Glassubstrats eine ITO-Schicht aufgebracht ist. Dabei werden zur Verarbeitung zwei Dünnglasscheiben mit Abstandshaltern miteinander verbunden und jeweils ihre Außenflächen weiter bearbeitet, z.B. mittels Dünnschichttechnik, so dass mit herkömmlichen Verarbeitungsmethoden bzw. herkömmlicher Ausrüstung dünnere Substrate als bisher bearbeitet werden können, wobei die beiden Substrate nach der Bearbeitung wieder getrennt werden. Dabei kann zusätzlich eine Metallbeschichtung auf die ITO-beschichteten Dünnglasscheiben aufgebracht werden. Sowohl die Beschichtung mit ITO als auch die Metallbeschichtung werden vollflächig aufgebracht und in einem späteren Verfahrensschritt mittels Dünnschichttechnik bzw. Litho/Ätzverfahren strukturiert. Dementsprechend können die Dünnschichtmuster als Leiterbahnen, z.B. als ITO-Bahnen für Abfrage- und Treiberleitung und/oder als Metallbahnen für Routing-Signale, ausgebildet sein.

Hierbei ist es jedoch nachteilig, dass die Strukturierung der metallischen Leitstrukturen mittels Dünnschichttechnik bzw. mittels Photolithographie in der Regel Vakuum erfordert und dementsprechend aufwendig und teuer ist.

Andererseits offenbart die EP 1 325 673 A1 eine Leiterplatte für eine elektronische Schaltung, wobei wenigstens eine Leiterschicht auf einer Dünnglasschicht angeordnet und mit dieser flächig verbunden ist. Dabei bestehen die Leiterschichten beispielsweise aus einer Kupfer-Metallfolie, die mit der Dünnglasschicht über eine Verbindungsschicht, die im Wesentlichen aus einem Harz besteht, verklebt wird. Solche harzbeschichteten Cu-Folien ("Resin Coated Foil" oder RCF) sind aus der Technik der HDI-Schaltungen bekannt. Die Leiterschicht kann dann wahlweise strukturiert werden, um bestimmte Leiterbahnen oder Leiterflächen zu erzeugen.

Darüber hinaus ist es auch bekannt, für den Druck von Leiterbahnen auf Dünnglas organische bzw. Zwei-Komponenten-Lacke zu verwenden. Bei solchen Sensorvorrichtungen ist es jedoch von Nachteil, dass solche Lacke bzw. Kleber gegenüber Umwelteinflüssen, UV-Strahlung, Klebstoffen in zusätzlich eingesetzten Materialien usw. häufig nicht ausreichend beständig sind und zudem ihre Haftung auf dem Glas verbesserungsbedürftig ist.

Die DE 31 11 696 A1 beschreibt eine Glasscheibe für ein mit einer Sicherheits-Steuerschaltung versehenes versenkbares Autofenster, mit einem als Berührungsfühler dienenden elektrischen Leitstreifen, der als Teil eines einen Oszillator umfassenden Detektorkreises geschaltet ist, am oberen Rand der Glasscheibe, bei dessen Bedämpfung über einen Grenzwert hinaus durch kapazitive Beeinflussung infolge Annäherung des Leitstreifens an einen Körperteil die Stromzufuhr zum Fensterhebermotor über die Steuerschaltung unterbrochen wird. Der elektrische Leitstreifen ist auf der inneren Oberfläche der Glasscheibe angeordnet. Ein als Verbindungsleitung zum Anschlussfeld für die elektronische Steuerschaltung dienender Abschnitt des Leitstreifens ist vorhanden, wobei in dem Feld zwischen der Verbindungsleitung und der Scheibenkante Schaltleitungen für zusätzliche Schaltfunktionen angeordnet sind. Entlang der oberen horizontalen Kante und entlang der schräg verlaufenden Kante auf der Innenseite der Fensterscheibe ist ein Fühler als aus einer druckfähigen Masse, insbesondere aus einer handelsüblichen keramischen Einbrennmasse, aufgedruckter Leitstreifen angeordnet.

Aufgabe der Erfindung war es vor diesem Hintergrund, eine kapazitive Sensorvorrichtung bereitzustellen, deren Aufbau eine große Beständigkeit und somit einen großen Einsatzbereich ermöglicht und die gleichzeitig einfach und kostengünstig herzustellen ist. Aufgabe der Erfindung war außerdem die Bereitstellung eines Verfahrens zur Herstellung einer solchen Sensorvorrichtung.

Die Lösung dieser Aufgabe wird nach dieser Erfindung erreicht durch eine kapazitive Sensorvorrichtung sowie ein Verfahren zu ihrer Herstellung mit den Merkmalen der entsprechenden unabhängigen Patentansprüche. Bevorzugte Ausführungsformen der erfindungsgemäßen Sensorvorrichtung sind in entsprechenden abhängigen Patentansprüchen aufgeführt. Bevorzugten Ausführungsformen der erfindungsgemäßen Sensorvorrichtung entsprechen bevorzugte Ausführungsformen des erfindungsgemäßen Verfahrens und umgekehrt, selbst wenn dies hierin nicht explizit festgestellt wird.

Gegenstand der Erfindung ist somit eine kapazitive Sensorvorrichtung mit einer Frontplatte aus Glas und einer elektrisch leitfähig beschichteten Sensorplatte aus Dünnglas, wobei auf der Sensorplatte eine keramische Leitstruktur aus einer eingebrannten keramischen Leitpaste angeordnet ist.

Hierin bedeutet eine kapazitive Sensorvorrichtung im Allgemeinen eine Sensorvorrichtung, bei der durch Annäherung und/oder Berührung von Sensorelektroden durch ein Objekt, beispielsweise mit einem Finger, einem Stift oder ähnlichem, ein durch Änderungen der elektrischen Kapazität hervorgerufenes elektrisches Signal erzeugt werden kann. Im Allgemeinen ist hierzu die Frontplatte dem Benutzer zugewandt, so dass die Annäherung und/oder Berührung an der Frontplatte erfolgt.

Erfindungsgemäß ist die Frontplatte aus Glas (hierin auch als "Glasfrontplatte" bezeichnet). Dies hat mehrere Vorteile. Der Aufbau der Sensorvorrichtung kann von einem Benutzer aus gesehen hinter der Glasfrontplatte liegen und die Sensorvorrichtung kann durch die Glasfrontplatte optisch ansprechend gestaltet werden. Zudem bietet Glas gute Witterungsbeständigkeit und gewährleistet somit den Schutz der Sensorvorrichtung. Hierfür kann die Glasfrontplatte eine ausreichende Dicke aufweisen, im Allgemeinen eine Dicke von 1 bis 10 mm, vorzugsweise von 2 bis 5 mm, besonders bevorzugt von 3 bis 4 mm. Zudem kann eine solche Front-Glasplatte den Aufbau der Sensorvorrichtung sowie ggf. weitere Komponenten gut tragen. Vorzugsweise wird für die Frontplatte Floatglas verwendet.

Außerdem ist Glas leicht zu reinigen, was den Einsatz auch in solchen Bereichen ermöglicht, in denen eine häufige Reinigung erforderlich ist, insbesondere auch in Bereichen, in denen es auf eine gute Hygiene ankommt. Weiterhin lassen sich auf Glas transparente und nicht-transparente Bereiche erzeugen, wobei transparente Bereiche insbesondere für eine Hinterlegung der Sensorvorrichtung mit einem Display vorteilhaft sind. Dabei können beispielsweise auf der Frontplatte Leuchtmittel wie Leuchtdioden angebracht sein. Außerdem kann die Frontplatte vorteilhaft entspiegelt sein und bevorzugt eine ESD-Schutzschicht zur Vorbeugung gegen elektrostatische Entladung (ESD, electrostatic discharge) aufweisen.

Bevorzugt weist die Frontplatte mindestens einen transparenten Bereich auf, insbesondere mehrere transparente und nicht-transparente Bereiche. Besonders bevorzugt ist der Sensorbereich der Sensorplatte vom Benutzer aus gesehen im Wesentlichen hinter dem transparente Bereiche aufweisenden Teil der Frontplatte angeordnet. Hinter einem nicht-transparenten Bereich ist vorteilhaft eine Auswerteelektronik für die elektrischen Signale der Sensorelektroden angeordnet. Ganz besonders bevorzugt ist vom Benutzer aus gesehen hinter der Sensorvorrichtung in transparenten Bereichen der Frontplatte ein Display angeordnet.

Auf einer ersten Oberfläche der Frontplatte ist vorzugsweise die Auswerteelektronik angeordnet oder zumindest angeschlossen. Im Allgemeinen handelt es sich bei der ersten Oberfläche der Frontplatte um die dem Benutzer abgewandte Oberfläche der Frontplatte. Somit befindet sich die Auswerteelektronik vorzugsweise auf der dem Benutzer abgewandten Seite der Frontplatte.

Der Begriff "Auswerteelektronik" umfasst elektronische Bauteile, Leiterbahnstrukturen, Lötverbindungen und ggf. weitere Komponenten. Die Auswerteelektronik kann beispielsweise direkt auf der Frontplatte, auf einem Flex-Kabel oder auf einer separaten Leiterplatte angeordnet sein. Bei Verwendung einer separaten Leiterplatte kann diese wiederum auf der ersten Oberfläche der Frontplatte angeordnet sein. In diesem Fall weist die Leiterplatte eine erste und eine zweite Seite auf, wobei Leiterbahnstrukturen, Lötverbindungen und elektronische Bauteile, und ggf. auch weitere Komponenten auf der ersten Seite der Leiterplatte angeordnet sind. Dabei kann die Leiterplatte auch zwei oder mehr Lagen, bevorzugt vier Lagen, aufweisen. Vorteilhaft ist die zweite Seite, d.h. die Seite ohne die genannten Bauelemente, auf geeignete Weise an der Frontplatte, insbesondere deren erster Seite, befestigt. Vorzugsweise weist die erfindungsgemäße kapazitive Sensorvorrichtung keine separate Leiterplatte auf.

Die Sensorplatte besteht aus Dünnglas (hierin auch als "Dünnglas-Sensorplatte" oder einfach als "Sensorplatte" bezeichnet). Unter "Dünnglas" wird hierin insbesondere ein Glas bzw. eine Glasscheibe mit einer Dicke von maximal 2,0 mm verstanden. Dabei kann es sich beispielsweise um gefloatetes oder gezogenes Glas handeln. Der Einsatz einer Dünnglasscheibe als Sensorplatte hat einerseits den Vorteil, dass durch die UV-Beständigkeit von Glas die erfindungsgemäße Sensorvorrichtung auch im Außenbereich gut einsetzbar ist. Insbesondere werden durch Verwendung einer Dünnglasscheibe als Sensorplatte sehr dünne Sensorvorrichtungen ermöglicht, die ein geringes Gesamtgewicht sowie eine geringe Gesamtdicke aufweisen.

Die Dünnglas-Sensorplatte weist vorteilhaft eine Dicke im Bereich von 0,2 bis 2,0 mm, vorzugsweise im Bereich von 0,3 bis 1,5 mm, besonders bevorzugt im Bereich von 0,5 bis 1,1 mm und ganz besonders bevorzugt im Bereich von 0,7 bis 1,1 mm auf. Die Dicke der Dünnglas-Sensorplatte ist dabei die Dicke ohne eine Beschichtung der Sensorplatte. Dadurch kann der Aufbau der erfindungsgemäßen Sensorvorrichtung dünn gehalten werden. Ein möglicher Parallaxenfehler, beispielsweise bei Vorhandensein eines hinter der Sensorvorrichtung angeordneten Displays, bleibt dann klein. Außerdem ist es bei Ausführungsformen, bei denen die Sensorplatte auf beiden Oberflächen elektrisch leitfähige Schichten aufweist, vorteilhaft, dass der Abstand zwischen diesen elektrischen Schichten gering ist. Außerdem kann auch die Sensorplatte vorteilhaft entspiegelt sein.

Auf der Sensorplatte ist mindestens eine keramische Leitstruktur aus einer eingebrannten keramischen Leitpaste angeordnet. Unter "Leitstruktur" wird hierin eine Struktur bzw. ein Muster aus elektrisch leitfähigen Elementen verstanden, beispielsweise aus Leiterbahnen und Widerständen. Vorzugsweise umfasst die Leitstruktur insbesondere Leiterbahnen, die einen möglichst geringen Widerstand aufweisen, vorteilhaft inklusive Pads, z.B. Lötpads und Anschlusspads. Zwischen Leitstruktur und Sensorplatte kann eine weitere Schicht vorhanden sein, beispielsweise eine Isolationsschicht oder eine die Schmelzverbindung verbessernde Schicht. Bevorzugt ist die Leitstruktur jedoch zumindest teilweise direkt auf der Sensorplatte angeordnet, d.h. ohne dass andere Materialien zwischen Leitstruktur und Sensorplatte angeordnet sind. Dabei ist es jedoch vorzugsweise nicht ausgeschlossen, dass die Leitstruktur auch teilweise nicht direkt auf der Sensorplatte angeordnet sein kann. Zudem können je nach Layout Überkreuzungen bzw. Tunnelungen vorkommen.

Die keramische Leitstruktur ist aus einer eingebrannten keramischen Leitpaste ausgebildet. Unter "keramischer Leitstruktur" wird hierbei insbesondere eine anorganische Leitstruktur verstanden. Eine solche keramische Leitstruktur, die aus einer eingebrannten keramischen Leitpaste ausgebildet ist, weist eine hohe Beständigkeit und gute Anhaftung auf dem Dünnglas auf, zudem kann hierauf eine Lötverbindung angebracht werden.

Unter "keramischer Leitpaste" wird eine einbrennbare Paste verstanden, die in der Regel sowohl eine keramische Komponente als auch eine Metallkomponente enthält. Solche Pasten sind beispielsweise im Bereich der Dickschichttechnik (auch als "Dickfilmtechnik" bezeichnet) bekannt. Neben der keramischen Komponente und der Metallkomponente enthalten solche einbrennbaren Pasten in der Regel weitere Zusätze wie z.B. ein Lösungsmittel, beispielsweise mindestens ein Alkohol wie Terpineol, das die Rheologie der Paste beeinflusst. Dies ist insbesondere bei einem Aufbringen der Paste mit einem Druckprozess von Bedeutung. Bevorzugt beträgt in der einbrennbaren Paste der Anteil der keramischen Komponente 10 - 20 Gew.-%, der Anteil der Metallpartikel, die vorzugsweise eine Korngröße von nicht mehr als 15 µm aufweisen, 55 - 85 Gew.-%, bevorzugt 60 - 80 Gew.-%, und der Anteil an Lösungsmittel 5 - 15 Gew.-%, jeweils bezogen auf die Gesamtheit der Leitpaste. Die keramische Leitpaste kann niedrig- oder hochschmelzend sein. Als niedrigschmelzende Paste wird hierin eine Paste mit einem Schmelzpunkt von 500 - 600°C, bevorzugt 500 - 540°C, und als hochschmelzende Paste wird eine Paste mit einem Schmelzpunkt von 600 - 700°C, bevorzugt von 650 - 680°C, verwendet.

Die keramische Komponente der Leitpaste bewirkt deren Anhaftung zum Glassubstrat, d.h. zur Sensorplatte. So kann während des Einbrennens der Keramikanteil der auf das Substrat aufgetragenen keramischen Leitpaste mit der Oberfläche der Dünnglas-Sensorplatte verschmelzen, so dass auf diese Weise eine feste Verbindung der keramischen Leitpaste mit der Dünnglas-Sensorplatte entsteht. So wird eine besonders gute Anhaftung zum Glassubstrat erreicht. Zudem wird so eine hohe Beständigkeit gegenüber Umwelteinflüssen wie z.B. UV-Strahlung und beispielsweise bei der Weiterverarbeitung verwendeten Klebstoffen ermöglicht.

Die keramische Komponente besteht hierbei im Allgemeinen aus anorganischen, nichtmetallischen Materialien, die in der Regel kristallin sind und metallische und nicht-metallische Elemente enthalten. Vorzugsweise ist die keramische Komponente Glasfritte. Ausdehnungskoeffizient und Schmelzbereich der Glasfritte sind vorteilhaft an das Trägersubstrat angepasst. Im Allgemeinen eignen sich als keramische Komponente besonders Metalloxide, Metallnitride, Metallcarbide oder eine Mischung dieser Materialien. Die keramische Komponente liegt in der Regel als Pulver oder in Form eines Dispergates vor.

Durch die Metallkomponente der Leitpaste wird eine möglichst hohe Leitfähigkeit der Leitpaste bereitgestellt. Dementsprechend sollte die Leitpaste gut leitende Materialien enthalten. Als Metallkomponente sind insbesondere Edelmetalle wie z.B. Silber, Gold, Platin und Palladium bevorzugt. Ganz besonders ist als keramische Leitpaste eine Silberleitpaste bevorzugt. Die genannten Edelmetalle können einzeln oder in Kombination verwendet werden. Auch Legierungen von Edelmetallen, beispielsweise aus Gold oder Silber mit Platin oder Palladium, können verwendet werden. Der Vorteil von Edelmetallen als Metallkomponente ist, dass diese nicht unter Schutzatmosphäre eingebrannt werden müssen. Darüber hinaus können auch Nichtedelmetalle als Metallkomponente verwendet werden, solange eine gute Leitfähigkeit und Beständigkeit gewährleistet sind. Auch diese Metalle können einzeln, in Kombination oder als Legierung, sowohl untereinander wie auch mit Edelmetallen eingesetzt werden. Bei Nichtedelmetall-enthaltenden Leitpasten sind solche, die Kupfer enthalten, bevorzugt.

In den keramischen Leitpasten beträgt der durchschnittliche Durchmesser der Metallpartikel im Allgemeinen nicht mehr als 15 µm, vorzugsweise von 1 bis 15 µm. Besonders bevorzugt weist die keramische Leitpaste Silberpartikel auf. In der eingebrannten keramischen Leitpaste sind die Metallpartikel im Allgemeinen derart miteinander in Kontakt, dass eine durchgehende elektrisch leitfähige Struktur vorliegt.

Im Allgemeinen beträgt die Breite der keramischen Leitstruktur aus einer eingebrannten keramischen Leitpaste nicht mehr als 1 mm, bevorzugt nicht mehr als 0,3 mm und besonders bevorzugt nicht mehr als 0,2 mm. Die Dicke (Höhe) der keramischen Leitstruktur aus einer eingebrannten keramischen Leitpaste beträgt vorzugsweise nicht mehr als 30 µm, besonders bevorzugt nicht mehr als 20 µm. Auf diese Weise kann eine besonders dünne Sensorvorrichtung erreicht werden.

Die Sensorvorrichtung weist im Allgemeinen Sensorelektroden auf. Diese können erfindungsgemäß insbesondere ebenso wie die keramische Leitstruktur aus einer eingebrannten keramischen Leitpaste ausgebildet sein oder aus einer im Wesentlichen transparenten, elektrisch leitfähigen Schicht bestehen.

In einer bevorzugten Ausführungsform der Sensorvorrichtung ist daher auf der Sensorplatte zusätzlich eine im Wesentlichen transparente, elektrisch leitfähige Schicht angeordnet, die vorzugsweise strukturiert ist.

"Im Wesentlichen transparent" bedeutet hierin, dass die elektrisch leitfähige Schicht zu mindestens 80% durchlässig ist in Bezug auf elektromagnetische Wellen, insbesondere im Bereich des sichtbaren Lichts. Insbesondere bedeutet "im Wesentlichen transparent" auch, dass die elektrisch leitfähige Schicht für den Betrachter der Sensorvorrichtung durchsichtig erscheint. Dies kann durch die Wahl entsprechender Materialien, wie beispielsweise Indiumzinnoxid (ITO), oder durch geeignete Strukturierung, wie beispielsweise mit Silber-Nanodrähten, die so dünn sind, dass sie vom Betrachter nicht wahrgenommen werden, erreicht werden.

Die im Wesentlichen transparente, elektrisch leitende Schicht wird vorzugsweise strukturiert, insbesondere wenn sie als gleichförmige Schicht auf einer Dünnglasplatte vorliegt, wobei hier die Strukturierung beispielsweise über einen Ätz- oder Laserablationsschritt erfolgt. Die Strukturierung wird in der Regel entsprechend der Funktion der elektrisch leitfähigen Schicht vorgenommen, also beispielsweise als Sensorelektrode oder als Leiterbahn zur Kontaktierung, wobei eine als Sensorelektrode strukturierte im Wesentlichen transparente, elektrisch leitfähige Schicht bevorzugt ist. Die Sensorelektroden können vielfältige Formen von einfachen geometrischen Formen, wie Kreise, Rechtecke usw., bis hin zu komplizierten unregelmäßigen Formen aufweisen. Bevorzugt sind Linien aus einem elektrisch leitfähigen Material in X- und Y-Richtung. Dabei können die Linien in X-Richtung von den Linien in Y-Richtung getrennt in mehreren elektrisch leitfähigen Schichten vorliegen oder gemeinsam in einer elektrisch leitfähigen Schicht, beispielsweise in einer gitterartigen Anordnung. Beispielsweise kann eine elektrisch leitfähige Schicht auf einer ersten Oberfläche der Sensorplatte vorliegen und/oder eine elektrisch leitfähige Schicht auf einer zweiten Oberfläche der Sensorplatte.

Die im Wesentlichen transparente, elektrisch leitfähige Schicht ist im Allgemeinen eine Halbleiteroxidschicht oder druckbare Elektronik wie Silber-Nanodrähte. Eine im Wesentlichen transparente, elektrisch leitfähige Halbleiteroxid-Schicht enthält vorzugsweise ITO, Zinkoxid, mit Antimon dotiertes Zinn(IV)-oxid (ATO), mit Aluminium dotiertes Zinkoxid (AZO) oder mit Fluor dotiertes Zinn(IV)-oxid (FTO) oder besteht aus diesen. Vorzugsweise ist die im Wesentlichen transparente, elektrisch leitfähige Halbleiteroxid-Schicht strukturiert, beispielsweise um als Sensorelektrode im Sinne der vorliegenden Erfindung, also insbesondere als kapazitive Sensorelektrode, verwendet zu werden.

Im Allgemeinen wird die im Wesentlichen transparente, elektrisch leitfähige Schicht durch Sputtern auf der Sensorplatte erzeugt. Andere Herstellungsmethoden sind möglich. Beispielsweise kann die Sensorplatte mit einem Film aus einem elektrisch leitfähigen Material mit einem geeigneten Druckverfahren, z.B. Siebdruck, auf die Sensorplatte aufgebracht und anschließend eingebrannt werden. Beispielsweise sind auch Dünnglasplatten mit einer ITO-Beschichtung auf einer oder auf beiden Seiten kommerziell erhältlich. Z.B. kann mit ITO beschichtetes Glas direkt im Rahmen einer Floatglas-Herstellung erhalten werden.

Besonders bevorzugt weist die eine im Wesentlichen transparente, elektrisch leitfähige Halbleiteroxid-Schicht auf der Sensorplatte Indium-Zinn-Oxid (ITO) auf. Beispielsweise wird eine ITO-Beschichtung entsprechend der Form der erwünschten Sensorelektroden durch einen Ätz- oder Laserablationsschritt strukturiert, um z.B. Linien in X- und/oder Y-Richtung zu erhalten.

Falls in der kapazitiven Sensorvorrichtung vorhanden, ist die im Wesentlichen transparente, elektrisch leitfähige Schicht vorzugsweise mit der keramischen Leitstruktur elektrisch leitfähig verbunden, so dass elektrische Signale von der im Wesentlichen transparenten, elektrisch leitfähigen Schicht über die keramische Leitstruktur und vorzugsweise über ein weiteres Element, wie z.B. ein Flex-Kabel, einen Federkontakt oder eine Metallklammer, an die Auswerteelektronik geleitet werden können. Bevorzugt werden die entsprechenden elektrischen Signale, beispielsweise von den X- und Y-Linien der Sensorelektroden, über die Leitstrukturen aus eingebrannter keramischer Leitpaste auf der Sensorplatte zu einem Anschluss an der Sensorplatte geleitet, z.B. zu einem Flex-Kabel oder einem Federkontakt, über das/den sie weiter zu der meist nicht auf der Sensorplatte befindlichen Auswerteelektronik geführt werden können.

Bevorzugt ist die mindestens eine keramische Leitstruktur und, falls vorhanden, auch die im Wesentlichen transparente, elektrisch leitfähige Schicht auf einer der Frontplatte zugewandten ersten Oberfläche der Sensorplatte angeordnet. Dies hat den Vorteil, dass der Abstand zwischen der zweiten Oberfläche der Frontplatte, auf der insbesondere eine Berührung durch einen Benutzer erfolgt, und den Sensorelektroden sehr gering gehalten wird, wodurch eine sehr genaue Abbildung der Berührung erzielt wird. Falls mehr als eine im Wesentlichen transparente, elektrisch leitfähige Schicht und/oder keramische Leitstruktur aus einer eingebrannten keramischen Leitpaste auf der der Frontplatte zugewandten ersten Oberfläche der Sensorplatte angeordnet werden, können diese ggf. voneinander getrennt angeordnet werden, indem geeignete, im Allgemeinen isolierende Schichten zwischen den elektrisch leitfähigen Schichten angebracht werden. Solche Schichten sind z.B. solche aus gedruckten Dickschicht-Isolationspasten, Siliziumdioxid (SiO₂)-enthaltende Schichten, die vorzugsweise aufgesputtert werden oder Filme aus einem Kunststoff oder einer Keramik, wobei SiO₂-Schichten bevorzugt werden. Vorzugsweise ist jedoch genau eine im Wesentlichen transparente, elektrisch leitfähige Schicht und/oder keramische Leitstruktur aus einer eingebrannten keramischen Leitpaste auf der der Frontplatte zugewandten ersten Oberfläche der Sensorplatte angeordnet.

In einer bevorzugten Ausführungsform der kapazitiven Sensorvorrichtung ist auf beiden Seiten der Sensorplatte jeweils mindestens eine keramische Leitstruktur angeordnet. Vorzugsweise ist hierbei auf beiden Seiten der Sensorplatte zusätzlich mindestens eine im Wesentlichen transparente, elektrisch leitfähige Schicht angeordnet. Die mindestens eine keramische Leitstruktur und gegebenenfalls auch die mindestens eine elektrisch leitfähige Schicht auf der der Frontplatte zugewandten ersten Oberfläche und die mindestens eine weitere keramische Leitstruktur und gegebenenfalls auch die mindestens eine weitere elektrisch leitfähige Schicht auf der der Frontplatte abgewandten zweiten Oberfläche sind durch die Sensorplatte voneinander getrennt. Bevorzugt umfasst eine im Wesentlichen transparente, elektrisch leitfähige Schicht auf der der Frontplatte zugewandten ersten Oberfläche Linien aus leitfähigem Material in X-Achsen-Richtung und eine weitere im Wesentlichen transparente, elektrisch leitfähige Schicht auf der der Frontplatte abgewandten zweiten Oberfläche Linien aus leitfähigem Material in Y-Achsen-Richtung oder umgekehrt.

Im Allgemeinen ist die Sensorplatte der ersten Oberfläche der Frontplatte zugewandt angeordnet. Dies bedeutet, dass die Sensorplatte im Allgemeinen vom Benutzer aus gesehen hinter der Frontplatte angeordnet ist. Vorteilhafterweise ist auf der ersten Oberfläche der Frontplatte auch die Auswerteelektronik angeordnet, so dass die Sensorplatte der Seite der Frontplatte mit der Auswertelektronik zugewandt ist, um eine vorteilhafte Verbindung von Sensorplatte und Auswerteelektronik zu ermöglichen.

Die Verbindung der Sensorplatte mit der Auswerteelektronik ist auf vielfältige Art und Weise möglich. Beispielsweise kann eine solche Verbindung über einen Federkontakt oder über ein Flex-Kabel erfolgen.

In einer bevorzugten Ausführungsform hat daher die kapazitive Sensorvorrichtung eine Frontplatte aus Glas und eine Sensorplatte aus Dünnglas, auf der eine keramische Leitstruktur aus einer eingebrannten keramischen Leitpaste und eine strukturierte im Wesentlichen transparente, elektrisch leitfähige Schicht angeordnet ist,
(a) wobei die Glas-Sensorplatte einer ersten Oberfläche der Frontplatte zugewandt ist;
(b) eine Auswerteelektronik für die elektrischen Signale direkt oder über eine Leiterplatte auf der ersten Oberfläche der Frontplatte angeordnet ist; und
(c) die mindestens eine elektrisch leitfähige Schicht mit der Auswerteelektronik über mindestens einen Federkontakt verbunden ist.
Vorzugsweise ist dabei der Federkontakt über eine Clip-Verbindung an der Sensorplatte befestigt. Im Allgemeinen kann der Federkontakt beispielsweise auch mittels Löten mit der keramischen Leitstruktur verbunden werden.

Gemäß einer noch mehr bevorzugten Ausführungsform der Erfindung erfolgt die Kontaktierung der Leitstrukturen auf der Sensorplatte über ein Flex-Kabel. Das Flex-Kabel ist in der Regel ein Flat-Flex-Kabel, wobei "Flat-Flex-Kabel" insbesondere solche der Typen FFC (flat flex cable) und FPC (flexible printed circuit) einschließt. Das Flat-Flex-Kabel ist im Allgemeinen ein mehradriges Kabel, indem die Adern nicht kreisförmig gebündelt, sondern - zumeist parallel - nebeneinander geführt sind. Das Flat-Flex-Kabel hat den Vorteil, dass durch die Vielzahl der Adern vielpolige Signalleitungen verbunden werden können, beispielsweise zur Leitung der Signale verschiedener Sensorbahnen, insbesondere der X-und Y-Linien. Durch das Flex-Kabel können auf diese Weise viele Adern mit wenig Aufwand verbunden werden. Das Flex-Kabel weist im Allgemeinen mehrere Adern auf, bevorzugt weist das Flex-Kabel mindestens 5 Adern auf, besonders bevorzugt mindestens 10 Adern. Der Abstand der Adern beträgt in der Regel 0,5 bis 2,54 mm, bevorzugt 1,27 mm.

Die Verbindung des Flex-Kabels mit der Sensorplatte kann auf verschiedene Weise erfolgen, beispielsweise mittels eines anisotrop leitfähigen Klebers. Es ist jedoch bevorzugt, dass das Flex-Kabel an die Sensorplatte, insbesondere an die keramische Leitstruktur auf der Sensorplatte, gelötet ist. Insbesondere ermöglicht die Verwendung einer keramischen Leitstruktur im Gegensatz zu beispielsweise organischen Lacken eine Lötverbindung. Bei dieser bevorzugten Ausführungsform ist somit das Flex-Kabel mittels einer verfestigten Lotpaste an der Sensorplatte fixiert. Der Lötprozess kann auf verschiedene Weise erfolgen, beispielsweise als Bügellötprozess, jedoch ist ein Reflow-Lötprozess bevorzugt. Insbesondere erfordern die Vielzahl der Adern des Flex-Kabels und deren vergleichsweise geringer Anstand einen präzisen Lötprozess. Durch das Löten ist das Flex-Kabel mit der keramischen Leitstruktur auf der Sensorplatte durch eine dauerstabile Lötverbindung verbunden, die große Beständigkeit gewährleistet und die sich im Zusammenhang mit der Leitstruktur aus keramischer Leitpaste über entsprechende Lötpads optimal umsetzen lässt. Zudem kann durch die Lötverbindung in Zusammenwirkung mit den keramischen Leitstrukturen eine komplett anorganische Sensorvorrichtung erhalten werden.

In der Regel werden die Leitstrukturen der Sensorplatte im Randbereich der Sensorplatte von dem Flex-Kabel kontaktiert. Insbesondere ist es bevorzugt, dass das Flex-Kabel die Leitstruktur der Sensorplatte in einem solchen Bereich kontaktiert, der vom Benutzer aus gesehen durch einen nicht-transparenten Bereich der Frontplatte verdeckt wird. Auf diese Weise ist durch die Anordnung des nicht-transparenten Bereichs der Frontplatte die Anbindung des Flex-Kabels für den Benutzer nicht sichtbar.

Vorzugsweise verbindet das eine Flex-Kabel bei dieser Ausführungsform die Leitstrukturen auf der Sensorplatte mit der Auswerteelektronik. Vorzugsweise wird dabei mindestens eine Sensorelektrode, die aus einer im Wesentlichen transparenten, elektrisch leitfähigen Schicht besteht, bevorzugt aus einem Halbleiteroxid, über die keramische Leitstruktur mit dem Flex-Kabel verbunden. Die Auswerteelektronik kann beispielsweise direkt auf der Frontplatte, auf dem Flex-Kabel oder auf einer separaten Leiterplatte angeordnet sein. Beispielsweise kann die Auswerteelektronik über die Chip-On-Flex-Technologie (COF) auf dem Flex-Kabel angeordnet sein.

Besonders bevorzugt ist eine Ausführungsform, die auf beiden Seiten der Sensorplatte jeweils mindestens eine keramische Leitstruktur aufweist und wobei die auf beiden Seiten der Sensorplatte angeordneten keramischen Leitstrukturen über ein einziges Flex-Kabel kontaktiert sind. Auch hier verbindet das Flex-Kabel die keramischen Leitstrukturen der Sensorplatte vorzugsweise mit der Auswerteelektronik. Dies ermöglicht, dass beispielsweise die auf einer Seite der Sensorplatte angeordneten Sensoren in X-Richtung und die auf der anderen Seite der Sensorplatte angeordneten Sensoren in Y-Richtung durch die keramischen Leitstrukturen, die aus einer eingebrannten keramischen Leitpaste ausgebildet sind, zu einem Anschluss für ein einziges Flex-Kabel zusammengeführt werden. Dabei ist die geringe Dicke der Dünnglas-Sensorplatte von Vorteil. Durch die Verwendung eines einzigen Flex-Kabels wird Material gespart und eine schnellere Montage ermöglicht.

In einer weiteren bevorzugten Ausführungsform ist auf der Sensorplatte eine Passivierungsschicht angeordnet. Die Passivierungsschicht ist hierbei insbesondere als Abschlussschicht auf den keramischen Leitstrukturen und gegebenenfalls der im Wesentlichen transparenten, elektrisch leitfähigen Schicht angeordnet. Die Passivierungsschicht besteht z.B. aus einem Keramikmaterial wie Siliziumnitrid oder Siliziumdioxid, wobei Siliziumdioxid bevorzugt ist. Vorzugsweise wird diese Schicht durch Sputtern erhalten. Die Passivierungsschicht bietet neben einem verbesserten Korrosionsschutz im Allgemeinen auch einen Haftgrund für nachfolgende Verfahrensschritte. Darüber hinaus kann eine solche Schicht als Isolation dienen und auch zwischen verschiedenen Schichten, die keramische Leitstrukturen und gegebenenfalls eine im Wesentlichen transparente, elektrisch leitfähige Schicht aufweisen, angeordnet sein. In diesem Fall ist insbesondere eine Siliziumdioxidschicht bevorzugt. Falls keine Isolation gewünscht ist, wird die keramische Leitstruktur beispielsweise mit einer Goldschicht überzogen, um die Korrosionsstabilität noch zu erhöhen und die Benetzung des Lotes noch weiter zu verbessern.

Weiterhin ist es bevorzugt, dass die Sensorvorrichtung mehrere elektrisch leitfähige Sensorschichten umfasst. Besonders bevorzugt weist die Sensorvorrichtung zwei, drei, vier oder fünf elektrisch leitfähige Sensorschichten auf. Auf diese Weise wird ein Mehrlagensensor ermöglicht, bei dem über zusätzliche Sensorschichten weitere Funktionen wie beispielsweise Proximity-Erkennung, Gestenerkennung etc. realisiert werden können.

Ein solcher Mehrlagensensor weist somit mehrere Sensorschichten auf und kann je nach Funktion und entsprechendem Design auch mehrere Passivierungsschichten und/oder Lackschichten umfassen. Insbesondere sind mehrere Schichten, die Leitstrukturen und/oder eine im Wesentlichen transparente, elektrisch leitfähige Schicht umfassen, durch Isolationsschichten, beispielsweise aus Siliziumdioxid, voneinander getrennt.

Die mehreren Sensorschichten können auch auf mehreren Dünnglas-Sensorplatten angeordnet sein. Besonders bevorzugt weist die Sensorvorrichtung zwei, drei, vier oder fünf Sensorplatten aus Dünnglas auf. Ganz besonders bevorzugt ist eine kapazitive Sensorvorrichtung mit zwei oder drei Sensorplatten.

Die mehreren Sensorplatten können beispielsweise gebondet werden oder als Polyvinylbutyral (PVB)-Verbund hergestellt werden. Bevorzugt erfolgt die Verbindung durch Bonden. Das Bonden erfolgt dabei vorzugsweise durch einen Spezialkleber, insbesondere einen OC-Kleber ("optically clear"). Dieser Kleber ist optisch klar, hoch transparent, vergilbungsstabil, hoch flexibel und hat eine hohe Haftung zu Glas. Vorzugsweise werden die gegebenenfalls eine Leitstruktur und/oder Schicht aufweisenden Sensorplatten vollflächig verklebt. Die Dicke der Klebschicht beträgt vorzugsweise 0,2 bis 0,5 mm.

In einer bevorzugten Ausführungsform ist die Sensorplatte mit der Frontplatte verklebt. Dabei ist eine Klebeschicht zwischen Sensor- und Frontplatte angeordnet. Bevorzugt wird hierbei ebenfalls ein Spezialkleber verwendet, besonders bevorzugt ein OC-Kleber. Vorzugsweise wird die gegebenenfalls eine Leitstruktur und/oder Schicht aufweisende Sensorplatte vollflächig mit der Frontplatte verklebt. Die Dicke der Klebschicht beträgt bevorzugt 0,2 bis 0,5 mm.

In einer weiteren Ausführungsform der kapazitiven Sensorvorrichtung ist zwischen der Frontplatte und der Sensorplatte mindestens ein Abstandshalter angeordnet. Diese Ausführungsform ist insbesondere bevorzugt, wenn die Kontaktierung der Leitstrukturen auf der Sensorplatte über Federkontakte erfolgt. Bei dieser Ausführungsform ist die Sensorplatte von der Frontplatte durch einen über den mindestens einen Abstandshalter definierten Abstand getrennt. So kann durch den mindestens einen Abstandshalter ein umlaufend gleicher Abstand zwischen Frontplatte und Sensorplatte erreicht werden.

Die Ausbildung des Abstandshalters ist nicht eingeschränkt. Jedoch werden bestückbare Bauelemente, wie SMD-Bauteile, beispielsweise Null-Ohm-Widerstände oder auch Kondensatoren oder Kupferblöcke, bevorzugt eingesetzt. Diese Bauelemente können beispielsweise in dem Bestückungsvorgang der Auswerteelektronik mit an der Frontplatte und/oder an einer zur Auswerteelektronik gehörenden Leiterplatte angebracht werden, so dass kein separater Arbeitsgang notwendig ist, um die Abstandshalter anzubringen. Andererseits sind auch andere Ausbildungen der Abstandshalter möglich, wie beispielsweise Kunststoffblöcke. Die Verbindung der Abstandshalter mit der Sensorplatte ist vorteilhaft elastisch, um die oben genannten Vorteile in größtmöglichem Umfang zu gewähren. Beispielsweise wird die Verbindung durch ein geeignetes Haftmaterial hergestellt, bevorzugt durch einen Epoxidharzkleber, der die Elastizität gewährleistet.

Die Anordnung der Abstandshalter erfolgt bevorzugt derart, dass die Abstandshalter für den Benutzer nicht sichtbar sind, beispielsweise in einem nicht-transparenten Bereich der Frontplatte und im Randbereich der Sensorplatte.

Insbesondere ist es bevorzugt, dass bei Verwendung eines Abstandhalters in der kapazitiven Sensorvorrichtung der Abstand zwischen der Frontplatte und Sensorplatte ≤ 1 mm, vorzugsweise ≤ 0,5 mm, besonders bevorzugt ≤ 0,4 mm beträgt. Wenn der Abstand größer ist, kann dies unter Umständen zu Verlusten bei der Genauigkeit der Registrierung des Touchsignals durch die Sensorelektroden, zu Parallaxenfehlern bei hinter der Sensorvorrichtung angeordnetem Display und/oder zu einem unerwünscht dicken Gesamtaufbau der Sensorvorrichtung führen. Besonders bevorzugt liegt der Abstand im Bereich von 0,2 bis 0,35 mm.

Weiterhin ist es bei der Abstandshalter aufweisenden Ausführungsform der erfindungsgemäßen Sensorvorrichtung bevorzugt, dass sich in dem durch die Abstandshalter zwischen Frontplatte und Sensorplatte definierten Zwischenraum ein Füllmaterial befindet. Ein solches Füllmaterial kann beispielsweise ein geeigneter Kleber sein, wie z.B. ein Epoxidharz oder ein OC-Kleber. Bevorzugt wird hier ein OC-Kleber eingesetzt. Das Füllmaterial hat einerseits den Vorteil, dass es den durch den Abstand gebildeten Zwischenraum zwischen Frontplatte und Sensorplatte abdichtet, so dass kein Schmutz eindringen kann. Andererseits ist es insbesondere bei großen Touchscreens mit dünnem Sensorglas möglich, dass durch die Berührung hervorgerufene Erschütterungen der Glasplatte zu einer ungenauen Abbildung der Berührung führen können. Dies kann durch ein geeignetes Füllmaterial vermieden werden.

Besonders bevorzugt ist bei der Abstandshalter aufweisenden Ausführungsform der erfindungsgemäßen Sensorvorrichtung die Auswerteelektronik direkt auf einer unbeschichteten oder beschichteten ersten Oberfläche der Frontplatte angebracht. Hierin bedeutet "direkt auf einer unbeschichteten oder beschichteten ersten Oberfläche der Frontplatte angebracht", dass die Auswerteelektronik insbesondere nicht auf einer Leiterplatte angebracht ist. Somit dient die Frontplatte aus Glas als Trägermaterial für die Elektronik. Auf diese Weise entfällt die Leiterplatte und eine vorteilhaft geringe Aufbauhöhe der Sensorvorrichtung ist möglich. Zudem entfällt der Arbeitsschritt der Befestigung der Leiterplatte an der Frontplatte.

In einer bevorzugten Ausführungsform der kapazitiven Sensorvorrichtung ist die erste Oberfläche der Frontplatte mindestens teilweise mit einer oder mehreren eingebrannten Keramikfarben beschichtet. Darüber hinaus kann auch auf der Sensorplatte eine Beschichtung mit einer eingebrannten Keramikfarbe vorliegen. Die einbrennbare Keramikfarbe hat dabei vorzugsweise eine Einbrenntemperatur, die sich nicht mehr als 20°C von der Einbrenntemperatur der einbrennbaren keramischen Leitpaste unterscheidet. Dies ermöglicht ein vorteilhaftes Einbrennen von Keramikfarbe und Leitpaste in einem Schritt. Eine Beschichtung mit Keramikfarbe kann als Dekorbeschichtung und/oder zur Bereitstellung eines nicht-transparenten Bereiches dienen. Die Beschichtung kann auf verschiedene Weise angebracht werden, beispielsweise durch Aufbringen eines Beschichtungsfilms oder durch geeignete Druckverfahren. Besonders bevorzugt ist das Anbringen der Beschichtung durch Siebdruck. Dabei werden zur Beschichtung besonders bevorzugt keramische und UV-stabile Siebdrucklacke verwendet.

Weiterhin ist es erfindungsgemäß bevorzugt, dass die Frontplatte der kapazitiven Sensorvorrichtung aus gehärtetem Einscheiben-Sicherheitsglas besteht. Dadurch wird eine kratzfeste Oberfläche und hohe mechanische Festigkeit erzielt. Außerdem dient dies dem Schutz der Sensorvorrichtung. Somit ist eine Vielzahl von Einsatzmöglichkeiten möglich, die beispielsweise eine robuste Oberfläche der Sensorvorrichtung erfordern. Insbesondere bietet sich hier eine Kombination mit der Ausführungsform an, bei der die Leiterbahnstrukturen der Auswerteelektronik auf der unbeschichteten oder beschichteten ersten Oberfläche der Frontplatte angebracht werden. Wenn solche Leiterbahnstrukturen und/oder Dekorschichten in die Glas-Frontplatte eingebrannt werden, kann dies durch geeignete Wahl der Brenntemperatur derart erfolgen, dass die Glas-Frontplatte gleichzeitig, also ohne zusätzlichen Arbeitsgang, zum Einscheiben-Sicherheitsglas gehärtet wird.

Bevorzugt ist eine kapazitive Sensorvorrichtung, bei der die beschichtete erste Oberfläche der Frontplatte erhältlich ist durch gleichzeitiges Einbrennen der Keramikfarben und/oder Leiterbahnstrukturen, beispielsweise bei einer Temperatur im Bereich von 600 bis 700°C.

Gegenstand der Erfindung ist außerdem ein Verfahren zur Herstellung einer kapazitiven Sensorvorrichtung mit einer Frontplatte aus Glas und einer elektrisch leitfähig beschichteten Sensorplatte aus Dünnglas, wobei auf der Sensorplatte eine keramische Leitstruktur aus einer eingebrannten keramischen Leitpaste angeordnet ist, und wobei das Verfahren die folgenden Schritte umfasst:
(ii) Aufbringen einer einbrennbaren keramischen Leitpaste auf die Sensorplatte aus Dünnglas und
(iv) Einbrennen der keramischen Leitpaste.

Die Art und Weise des Aufbringens der einbrennbaren keramischen Leitpaste auf die Sensorplatte aus Dünnglas in Schritt (ii) ist erfindungsgemäß nicht besonders eingeschränkt. Jedoch ist es bevorzugt, dass das Aufbringen in Schritt (ii) mittels Siebdruck- oder Tintenstrahltechnik durchgeführt wird. Dies hat den Vorteil, dass kommerziell erhältliche einbrennbare keramische Leitpasten verwendet werden können, die in der Regel auf diese Verfahren abgestimmt sind. Besonders bevorzugt ist die Siebdrucktechnik, da es sich hierbei um ein effizientes und kostengünstiges Verfahren handelt, insbesondere auch hinsichtlich der Anlagentechnik und der auf Siebdruck abgestimmten keramischen Leitpasten. Insbesondere wenn eine besonders hohe Auflösung gefordert ist, beispielsweise hinsichtlich Strukturen unter 50 µm, ist die Tintenstrahltechnik bevorzugt, die im Gegensatz zum Siebdruck keine Masken erfordert und noch bessere Auflösung bietet. Weiterhin kann das Aufbringen in Schritt (ii) auch durch andere Techniken erfolgen, beispielsweise durch lasergestützte digitale Druckverfahren wie z.B. die LIFT-Technologie, wobei es sich um ein düsen- und berührungsloses Verfahren handelt.

Beim Aufbringen der einbrennbaren keramischen Leitpaste kann bereits eine gewünschte Strukturierung vorgenommen werden, die beim anschließenden Einbrennen der keramische Leitpaste fixiert werden kann.

Im Anschluss an das Aufbringen der einbrennbaren keramischen Leitpaste (Schritt (ii)) und vor dem Einbrennen (Schritt (iv)) erfolgt vorzugsweise ein Trocknungsschritt (iii). Hierbei können Lösungsmittel aus der Paste verdampft werden. Beispielsweise kann die Paste einige Minuten bei Raumtemperatur vorgetrocknet werden und anschließend bei einer Temperatur von 80 bis 150°C für 5 bis 15 min getrocknet werden, wobei die genauen Temperaturen und Zeiten insbesondere von der verwendeten Paste abhängen. Der Trocknungsschritt hat den Vorteil, dass eine spontane Verdampfung der Lösungsmittel bei einer hohen Einbrenntemperatur vermieden wird, die zu Blasen oder Rissen führen könnte.

In Schritt (iv) erfolgt das Einbrennen der keramischen Leitpaste, wobei die Pastenpartikel, insbesondere beispielsweise die Glasfritte-Partikel, zumindest teilweise mit der Oberfläche der Dünnglas-Sensorplatte verschmelzen. Durch die anschließende Abkühlung des Substrats erstarrt der Keramikanteil, z.B. die Glasfritte, in der Paste und bildet so eine feste mechanische Verbindung zum Substrat. Somit werden die guten Hafteigenschaften der Leitstrukturen auf der Sensorplatte ermöglicht.

Die Einbrenntemperatur liegt vorzugsweise zwischen 500 - 700°C, besonders bevorzugt zwischen 500 - 540°C bei Verwendung niedrig schmelzender Pasten oder zwischen 650 - 680°C bei Verwendung hoch schmelzender Pasten.

Das Einbrennen der einbrennbaren keramischen Leitpaste kann unter sehr unterschiedlichen Bedingungen durchgeführt werden. Die im Verfahren gewählten Bedingungen werden im Allgemeinen von der keramischen Leitpaste und der gewünschten Planarität des Dünnschichtglases während des Einbrennens abhängen. Beispielsweise werden vorteilhaft niedrig schmelzende Silberpasten mit einem Schmelzbereich von 500 bis 540°C oder IRabsorbierende Leitpasten eingesetzt. Bei einer bevorzugten Einbrenntemperatur im Bereich von 500° bis 700°C sollte die Planarität des Dünnglases im Wesentlichen erhalten bleiben. Es hat sich erfindungsgemäß als besonders vorteilhaft herausgestellt, wenn beim Einbrennen im Schritt (iv) eine Planarität von ≤ 0,05 mm eingehalten werden kann.

Zu diesem Zweck erfolgt das Einbrennen im Allgemeinen unter Verwendung von speziellen horizontalen Aufnahmevorrichtungen für Durchlaufofen oder von speziellen vertikalen Aufnahmen für Batchofen.

Außerdem werden im Allgemeinen Einbrennparameter wie z.B. die Temperatur, Aufheizzeit, Oszillationsgeschwindigkeit, Luftdruck beim Abkühlen, Abkühlzeit und/oder die Wahl einer geeigneten Wärmequelle, wie z.B. Heizwendel, IR-Strahler, Laserstrahlvorrichtung mit hoher Energiedichte zum punktuellen Einbrennen, geeignet auf die Leitpaste und die Glassensorplatte abgestimmt.

In einer bevorzugten Ausführungsform ist auf der Sensorplatte zusätzlich eine strukturierte im Wesentlichen transparente, elektrisch leitfähige Schicht, insbesondere eine Halbleiteroxid-Schicht, angeordnet. Vorzugsweise befindet sich diese als mehr oder weniger kohärente Beschichtung, z.B. aus ITO, direkt auf der Sensorplatte. Es wird daher beim erfindungsgemäßen Verfahren im Allgemeinen vor der Durchführung der Schritte (ii) und (iv) in einem Schritt (i) eine Strukturierung der elektrisch leitfähigen Metalloxid-Schicht durchgeführt. Die Strukturierung erfolgt im Allgemeinen über einen Ätzschritt oder einen Laserablationsschritt. In einem Ätzschritt wird im Allgemeinen eine geeignete Ätzpaste auf die zu entfernenden Teile der Halbleiteroxid-Schicht aufgebracht. Dies kann vorteilhaft mittels Siebdruck erfolgen. Geeignete Ätzpasten sind insbesondere Phosphorsäure enthaltende Ätzpasten. Besonders bevorzugt werden HF- und chloridfreie, siebdruckgeeignete Ätzpasten verwendet.

Alternativ oder in Ergänzung hierzu kann eine Strukturierung der Halbleiteroxid-Schicht durch die Einwirkung einer geeigneten Laserstrahlung erreicht werden. In einem sogenannten Laserablationsschritt wird hierbei durch die Laserstrahlung das Halbleiteroxid an einer bestrahlten Stelle entfernt. Die Strukturierung von ITO-Beschichtungen mit Laserstrahlung erfolgt insbesondere in Abhängigkeit von der Glasdicke der Sensorplatte, deren Beschichtung, insbesondere der Beschichtungsdicke und der gewünschten Auflösung. Beispielsweise können hier luftgekühlte Lasersysteme mit einem Laser vom Typ Nd: YAG mit λ = 532 nm und mit maximaler mittlerer Leistung von 4,5 W oder vom Typ Nd: YAG mit λ = 1064 nm und mit maximaler mittlerer Leistung von 15 W eingesetzt werden.

Auf diese Weise werden insbesondere die erwünschten Sensorstrukturen erhalten. Zudem können insbesondere bei vorgefertigten ganzflächig mit einer elektrisch leitfähigen Schicht beschichteten Dünnglasscheiben Bereiche erhalten werden, die frei von der im Wesentlichen transparenten, elektrisch leitfähigen Schicht sind und auf denen im Schritt (ii) die Leitstruktur aufgebracht werden kann.

In einer weiteren bevorzugten Ausführungsform werden nach der Durchführung der Schritte (ii) und (iv) und ggf. der Schritte (i) und/oder (iii) die folgenden Schritte durchgeführt:
(iv) Belotung der keramischen Leitstruktur an den zur Verbindung mit einem Flex-Kabel vorgesehenen Stellen und/oder des Flex-Kabels; und
(v) Löten zur Verbindung des Flex-Kabels mit der keramischen Leitstruktur auf der Sensorplatte.

Die Art und Weise des Lötens ist erfindungsgemäß nicht eingeschränkt, wobei jedoch Präzision insbesondere hinsichtlich des geringen Abstands der mehreren Adern des Flex-Kabels erforderlich ist. Beispielsweise kann das Löten durch Bügellöten, Thermodenlöten oder Reflowlöten erfolgen, wobei Reflowlöten bevorzugt ist.

Beim Reflowlöten (auch "Wiederaufschmelzlöten") wird die Lotpaste bzw. die keramische Leitstruktur nur auf die erforderliche Löttemperatur erwärmt. Der Lotauftrag erfolgt unabhängig davon bereits vor der Bestückung mit elektronischen Bauteilen. In Schritt (iv) wird hier vorzugsweise nur die keramische Leitstruktur der Sensorplatte an den vorgesehenen Kontaktstellen, d.h. an den Lötpads, belotet. Die Belotung, d.h. das Aufbringen von Lötmittel, kann auf vielfältige Weise, z.B. mit Lotpaste, Lotformteilen, Belotung im Tauch- oder Wellenbad oder elektrochemische Beschichtung erfolgen. Bevorzugt wird Lotpaste verwendet. Lotpaste hat den Vorteil, dass das Flex-Kabel durch das in der Lotpaste im Allgemeinen enthaltene, klebrige Flußmittel bis zur Lötung auf der Leitstruktur fixiert werden kann. So können auch kleinste Kontaktflächen präzise belotet werden.

In einer besonders bevorzugten Ausführungsform des Verfahrens wird eine kapazitive Sensorvorrichtung mit auf beiden Seiten der Sensorplatte jeweils angeordneten keramischen Leitstrukturen, die über ein einziges Flex-Kabel kontaktiert werden, nach dem zuvor beschriebenen Verfahren mittels Reflowlöten hergestellt, wobei auf einer ersten Seite der Sensorplatte das Flex-Kabel mit einer Lotpaste, die einen Schmelzbereich von 225 - 250°C, bevorzugt von 230 - 245°C, aufweist, befestigt wird. Wenn auf der ersten Seite der Sensorplatte die Verbindung des Kabels mit den Leitstrukturen durch Reflowlöten hergestellt ist, wird auf einer zweiten Seite der Sensorplatte das Kabel mit einer niedrig schmelzenden Lotpaste mit einem Schmelzbereich von 160 bis 180°C, bevorzugt von 165 bis 175°C, angelötet. Auf diese Weise kann die bereits hergestellte Lötverbindung auf der ersten Seite der Sensorplatte ohne Beschädigung einen weiteren Reflowlötprozess überstehen. Alternativ kann für beide Seiten auch die gleiche Lotpaste verwendet werden und die Temperatureinstellung der Ober- und Unterhitze entsprechend angepasst werden.

Die Erfindung hat zahlreiche Vorteile. Die erfindungsgemäße kapazitive Sensorvorrichtung vereint die Möglichkeit einer breiten Anwendbarkeit mit einer einfachen und kostengünstigen Herstellung. Diese kapazitive Sensorvorrichtung kann in vielen Bereichen eingesetzt werden, beispielsweise für Sensorvorrichtungen mit PCT-Technologie, für Außenanwendungen oder für sonstige Bereiche, in denen robuste Ausführungen gefordert sind. Durch den Einsatz einer Dünnglasscheibe als Sensorplatte werden im Gesamtaufbau sehr dünne Sensorvorrichtungen ermöglicht, die zudem ein geringeres Gewicht aufweisen. Gleichzeitig gewährleistet die Verwendung einer eingebrannten keramischen Leitpaste zur Ausbildung der Leitstrukturen eine hervorragende Anhaftung der Leitstrukturen an das Dünnglassubstrat sowie eine hohe Beständigkeit gegenüber Umwelteinflüssen, UV-Strahlung und chemischen Einflüssen, beispielsweise auch gegenüber in späteren Verfahrensschritten eingesetzten Klebstoffen. So wird die Weiterverarbeitbarkeit erleichtert und ein breiter Einsatzbereich ermöglicht.

Die Erfindung wird im Folgenden anhand von zwei nicht einschränkend gemeinten Ausführungsbeispielen für eine erfindungsgemäße Sensorvorrichtung illustriert.

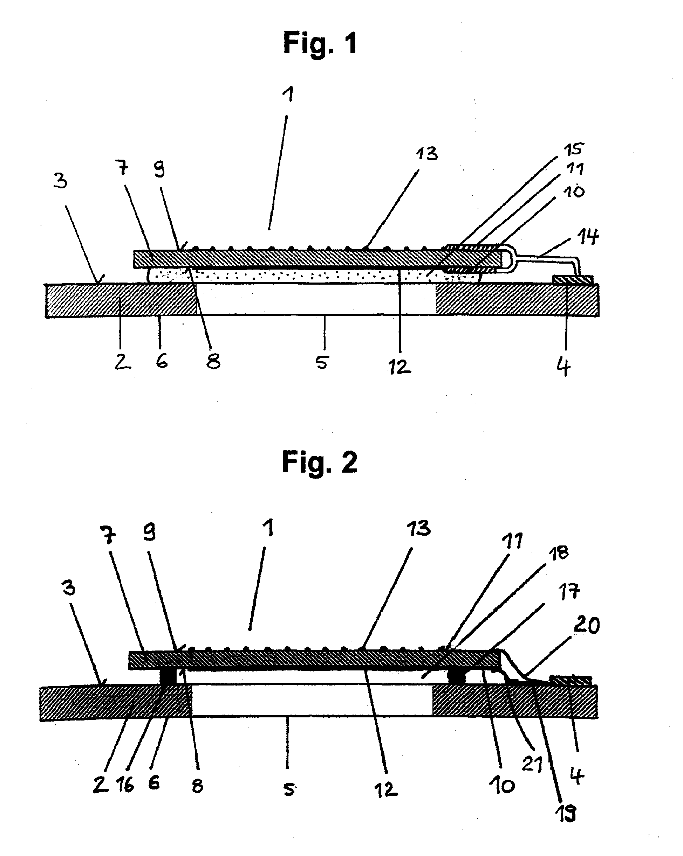

Fig. 1 zeigt einen Querschnitt durch eine erfindungsgemäße kapazitive Sensorvorrichtung gemäß einer ersten Ausführungsform der Erfindung, bei der auf beiden Seiten der Sensor-Dünnglasplatte jeweils eine keramische Leitstruktur und eine strukturierte im Wesentlichen transparente, elektrisch leitfähige Schicht angeordnet ist, wobei die auf beiden Seiten angeordneten Leitstrukturen sowie elektrisch leitfähigen Schichten über ein einziges Flex-Kabel kontaktiert sind.

In der Figur 1 ist ein Querschnitt durch eine nicht einschränkend gemeinte Ausführungsform einer erfindungsgemäßen kapazitiven Sensorvorrichtung 1 gezeigt. Die kapazitive Sensorvorrichtung 1 umfasst eine Frontplatte 2 aus Glas mit einer Dicke von 3 mm. Auf einer ersten Oberfläche 3 der Frontplatte 2 ist eine Auswerteelektronik 4 angeordnet. Die Frontplatte 2 weist einen im Wesentlichen transparenten Bereich 5 und einen nicht-transparenten Bereich 6 auf.

Weiterhin umfasst die kapazitive Sensorvorrichtung 1 eine Sensorplatte 7 aus Dünnglas mit einer Dicke von 1,1 mm. Die erste Oberfläche 8 der Sensorplatte 7 ist der ersten Oberfläche 3 der Frontplatte 2 zugewandt angeordnet. Die Sensorplatte 7 weist somit eine der Frontplatte 2 zugewandte erste Oberfläche 8 und eine der Frontplatte 2 abgewandte zweite Oberfläche 9 auf. Auf beiden Seiten der Sensorplatte 7, also auf beiden Oberflächen 8 und 9, ist jeweils direkt eine keramische Leitstruktur 10 und 11 angeordnet, die aus einer eingebrannten keramischen Silberpaste, z.B. mit einer siebdruckgeeigneten Silberleitpaste mit einem Silbergehalt von 60% oder 80%, ausgebildet ist und die Leiterbahnen und Lötpads umfasst. Zudem ist auf beiden Seiten der Sensorplatte 7, also auf beiden Oberflächen 8 und 9, jeweils eine strukturierte im Wesentlichen transparente, elektrisch leitfähige Schicht 12 und 13 angeordnet, die hier als ITO-Schicht ausgebildet ist. Die erste ITO-Schicht 12 ist derart strukturiert, dass sie Linien in X-Richtung bildet und die zweite ITO-Schicht 13 ist derart strukturiert, dass sie Linien in Y-Richtung bildet, so dass aus beiden ITO-Schichten 12 und 13 der Sensor gebildet wird. Im Randbereich der Sensorplatte 7 werden (hier nicht sichtbar) die jeweiligen X- und Y-Linien der ITO-Schichten 12 und 13 von den Leiterbahnstrukturen aus keramischer Silberleitpaste 10 und 11 kontaktiert. Die Leiterbahnstrukturen 10 und 11 werden ihrerseits zu einer Anschlussstelle für ein Flex-Kabel 14 mit entsprechenden Lötpads zusammengeführt (hier nicht sichtbar), die ebenfalls im Randbereich der Sensorplatte 7 liegt und für den Benutzer durch den nicht-transparenten Bereich 6 der Frontplatte 2 verdeckt wird.

Die elektrische Verbindung zwischen der auf der Frontplatte 2 angeordneten Auswerteelektronik 4 und den Leitstrukturen 10 und 11 der Sensorplatte 7 ist durch ein Flex-Kabel 14 realisiert. Das Flex-Kabel 14 kontaktiert abwechselnd sowohl die Leitstrukturen 10 auf der der Frontplatte 2 zugewandten ersten Oberfläche 8 der Sensorplatte 7 sowie auch die Leitstrukturen 11 auf der der Frontplatte 2 abgewandten zweite Oberfläche 8 der Sensorplatte 7. Die Verbindung des Flex-Kabels 14 mit den Leitstrukturen 10 und 11 ist durch eine Lötverbindung mittels einer verfestigten Lotpaste (hier nicht sichtbar) realisiert.

Zwischen der Frontplatte 2 und der Sensorplatte 7 befindet sich bei dieser Ausführungsform eine Klebeschicht 15. Diese Klebeschicht 15 ist vollflächig, also ohne Unterbrechungen oder Hohlräume, ausgebildet und besteht hier aus einem OC-Kleber (optically clear adhesive).

Zur Durchführung des erfindungsgemäßen Verfahrens wird bei der hier gezeigten ersten Ausführungsform zunächst die als Sensorplatte 7 dienende, ganzflächig mit ITO beschichtete Dünnglasplatte durch Ätzen strukturiert, so dass Sensorlinien in X- (Schicht 12) bzw. in Y-Richtung (Schicht 13) sowie ITO-freie Bereiche, insbesondere im Randbereich der Sensorplatte 7, entstehen. Der Ätzschritt wird hierbei je Seite 8 und 9 der Sensorplatte 7 durchgeführt, indem Ätzpaste, beispielsweise eine HF- und chloridfreie, siebdruckgeeignete Ätzpaste, mittels Siebdrucktechnik durch ein Sieb mit den entsprechenden X- oder Y-Linien aufgedruckt wird, die Ätzpaste dann thermisch aktiviert wird, beispielsweise für 15 min bei 150°C, und anschließend gewaschen wird. In den so entstandenen ITO-freien Bereichen wird dann mittels Siebdruck die keramische Silberleitpaste auf der ersten Oberfläche 8 und anschließend auf der zweiten Oberfläche 9 der Sensorplatte 7 aufgebracht. Die Paste wird dann zunächst bei Raumtemperatur für 5 min und dann bei 120 bis 150 °C für 5 bis 10 min getrocknet. Anschließend wird die Silberleitpaste bei einer Temperatur zwischen 500 und 700 °C eingebrannt.

Im Anschluss wird die Frontplatte 2 mit der Auswerteelektronik 4 mittels SMD-Löten bestückt. Anschließend werden die bei den Leitstrukturen 10 zum Anschluss für das Flex-Kabel 14 vorgesehenen Lötpads mit einer Lotpaste, die einen Schmelzbereich von 230 - 245°C aufweist belotet, das Flex-Kabel 14 daran fixiert und mittels Reflowlötprozess verlötet. Danach werden die bei den Leitstrukturen 11 zum Anschluss für das Flex-Kabel 14 vorgesehenen Lötpads mit einer Lotpaste, die einen Schmelzbereich von ca. 170°C aufweist, belotet, das Flex-Kabel 14 daran ebenfalls fixiert und mittels Reflowlötprozess verlötet. Im Anschluss wird ein OC-Kleber im vorgesehenen Bereich vollflächig auf die Frontplatte 2 und/oder auf die Sensorplatte 7 aufgebracht. Dann wird die Sensorplatte 7 durch einfaches Andrücken an der Frontplatte 2 angebracht. Durch die vorbereitete Klebeschicht 15 haftet die Sensorplatte 7 an der Frontplatte 2.

Fig. 2 zeigt einen Querschnitt durch eine erfindungsgemäße kapazitive Sensorvorrichtung 1 gemäß einer zweiten Ausführungsform der Erfindung, bei der auf beiden Seiten 8 und 9 der Sensor-Dünnglasplatte 7 jeweils eine keramische Leitstruktur 10, 11 und eine strukturierte im Wesentlichen transparente, elektrisch leitfähige Schicht 12, 13 angeordnet ist. Im Unterschied zu der ersten Ausführungsform von Fig. 1 befinden sich hier zwischen der Frontplatte 2 und der Sensorplatte 7 Abstandshalter 16, 17 welche bei der hier gezeigten Ausführungsform mittels eines Epoxidklebers mit der Frontplatte 2 verklebt sind. Durch die Abstandshalter 16 und 17 ist ein Zwischenraum 18 zwischen Frontplatte 2 und Sensorplatte 7 gebildet. Die Bestückung der Frontplatte 2 mit den Abstandshaltern 16, 17 erfolgt im gleichen Arbeitsgang wie die Bestückung der Frontplatte 2 mit der Auswerteelektronik 4. Zudem sind bei dieser Ausführungsform die auf beiden Seiten 8 und 9 angeordneten Leitstrukturen 10, 11 sowie die elektrisch leitfähigen Schichten 12, 13 über zwei Federkontakte 20 und 21, die hier als Metallklammern ausgebildet sind, und eine elektrische Leitungsstruktur 19 auf der Frontplatte 2 mit der Auswerteelektronik 4 verbunden. Ansonsten haben gleiche Bezugszeichen die gleiche Bedeutung wie in Fig. 1.

### Bezugszeichenliste

- 1: Kapazitive Sensorvorrichtung
- 2: Frontplatte aus Glas
- 3: Erste Oberfläche der Frontplatte
- 4: Auswerteelektronik
- 5: Im Wesentlichen transparenter Bereich der Frontplatte
- 6: Nicht-transparenter Bereich der Frontplatte
- 7: Sensorplatte aus Dünnglas
- 8: Erste Oberfläche der Sensorplatte, der Frontplatte zugewandt
- 9: Zweite Oberfläche der Sensorplatte, der Frontplatte abgewandt
- 10, 11: keramische Leitstrukturen aus eingebrannter keramischer Leitpaste
- 12, 13: strukturierte im Wesentlichen transparente, elektrisch leitfähige Schicht
- 14: Flex-Kabel
- 15: Klebeschicht
- 16, 17: Abstandshalter
- 18: Zwischenraum
- 19: elektrische Leitungsstruktur auf Frontplatte
- 20, 21: Federkontakte

## Patentansprüche

1. Kapazitive Sensorvorrichtung (1) mit einer Frontplatte (2) aus Glas und einer elektrisch leitfähig beschichteten Sensorplatte (7) aus Dünnglas,
**dadurch gekennzeichnet, dass** auf der Sensorplatte eine keramische Leitstruktur (10,11) aus einer eingebrannten keramischen Leitpaste angeordnet ist.

2. Sensorvorrichtung (1) nach Anspruch 1, **dadurch gekennzeichnet, dass** auf der Sensorplatte (7) zusätzlich eine strukturierte im Wesentlichen transparente, elektrisch leitfähige Schicht (12,13) angeordnet ist.

3. Sensorvorrichtung (1) nach einem der Ansprüche 1 oder 2, **dadurch gekennzeichnet, dass** auf beiden Seiten der Sensorplatte (7) jeweils mindestens eine keramische Leitstruktur (10,11) angeordnet ist.

4. Sensorvorrichtung (1) nach Anspruch 3, **dadurch gekennzeichnet, dass** die auf beiden Seiten der Sensorplatte (7) angeordneten keramischen Leitstrukturen (10,11) über ein einziges Flex-Kabel (14) kontaktiert sind.

5. Sensorvorrichtung (1) nach Anspruch 4, **dadurch gekennzeichnet, dass** das Flex-Kabel (14) mittels einer verfestigten Lotpaste an der Sensorplatte (7) fixiert ist.

6. Sensorvorrichtung (1) nach einem der Ansprüche 1 bis 3, **dadurch gekennzeichnet, dass** zwischen Frontplatte (2) und Sensorplatte (7) mindestens ein Abstandshalter (16,17) angeordnet ist und die keramische Leitstruktur (10,11) der Sensorplatte (7) über mindestens einen Federkontakt (20,21) kontaktiert ist.

7. Sensorvorrichtung (1) nach einem der Ansprüche 1 bis 6, **dadurch gekennzeichnet, dass** das Dünnglas der Sensorplatte (7) eine Dicke von 0,2 bis 2,0 mm aufweist.

8. Sensorvorrichtung (1) nach einem der Ansprüche 1 bis 7, **dadurch gekennzeichnet, dass** die eingebrannte keramische Leitpaste Silber aufweist.

9. Sensorvorrichtung (1) nach einem der Ansprüche 1 bis 8, **dadurch gekennzeichnet, dass** auf der Sensorplatte (7) eine Passivierungsschicht angeordnet ist.

10. Sensorvorrichtung (1) nach einem der Ansprüche 1 bis 9, **dadurch gekennzeichnet, dass** die Sensorvorrichtung (1) mehrere elektrisch leitfähige Sensorschichten (12,13) umfasst.

11. Verfahren zur Herstellung einer kapazitiven Sensorvorrichtung (1) mit einer Frontplatte (2) aus Glas und einer elektrisch leitfähig beschichteten Sensorplatte (7) aus Dünnglas, wobei auf der Sensorplatte (7) eine keramische Leitstruktur aus einer eingebrannten keramischen Leitpaste angeordnet ist,
**dadurch gekennzeichnet, dass** es die folgenden Schritte umfasst:
(ii) Aufbringen einer einbrennbaren keramischen Leitpaste auf die Sensorplatte (7) aus Dünnglas und
(iv) Einbrennen der keramischen Leitpaste.

12. Verfahren nach Anspruch 11, **dadurch gekennzeichnet dass** das Aufbringen der keramischen Leitpaste in Schritt (ii) mittels Siebdruck- oder Tintenstrahltechnik durchgeführt wird.

13. Verfahren nach Anspruch 11 oder 12, **dadurch gekennzeichnet, dass** die Einbrenntemperatur in Schritt (iv) im Bereich von 500 bis 700°C liegt.

14. Verfahren nach einem der Ansprüche 11 bis 13, **dadurch gekennzeichnet, dass** auf der Sensorplatte (7) zusätzlich eine elektrisch leitfähige Halbleiteroxid-Schicht (12,13) angeordnet ist, die vor der Durchführung der Schritte (ii) und (iv) einem Strukturierungsschritt (i) unterzogen wird.

15. Verfahren nach einem der Ansprüche 11 bis 14, **dadurch gekennzeichnet, dass** nach der Durchführung der Schritte (ii) und (iv) die folgenden Schritte durchgeführt werden:
(v) Belotung der Leitstruktur (10,11) an den zur Verbindung mit einem Flex-Kabel (14) vorgesehenen Stellen und/oder des Flex-Kabels (14); und
(vi) Löten zur Verbindung des Flex-Kabels (14) mit der Sensorplatte (7).
